# EUROPEAN PATENT APPLICATION

(11) **EP 4 661 618 A1**
(43) Date of publication of application: **10.12.2025**
(21) Application number: 24217333.4
(22) Date of filing: 04.12.2024
(51) Int. Cl.: H10D 62/10, H10D 8/50, H10D 64/00

(54) **DIODE DEVICE WITH FIELD PLATE STRUCTURE**

(30) Priority: 07.06.2024 US 202418736686
(71) Applicant: GlobalFoundries U.S. Inc., Malta, NY 12020 (US)
(72) Inventor: Borisov, Kiril Biserov, 1700 Sofia (BG); Darwish, Mohammed Ahmed Fouad Ibrahim, 01109 Dresden (DE); Ramadout, Benoit Francois Claude, 01109 Dresden (DE)
(74) Representative: Grünecker Patent- und Rechtsanwälte PartG mbB

(57) **Abstract**

A diode device includes a first well in a semiconductor substrate, a second well in the semiconductor substrate surrounding the first well, and a low-doped region between the first well and the second well in the semiconductor substrate. The first well and the second well have opposite conductivity types, creating a PIN diode. The diode device also includes a field plate structure over the low-doped region between the wells. The field plate structure includes a single crystal semiconductor over a first dielectric layer and/or a polyconductor gate over a second dielectric layer. The field plate structure provides high voltage isolation resulting in increased breakdown voltage for the PIN diode at reduced costs compared to conventional processes. In certain embodiments, the diode device may have a breakdown voltage of greater than 35 Volts.

## Description

### BACKGROUND

The present disclosure relates to semiconductor structures and, more particularly, to a diode device having a field plate structure integrated to increase breakdown voltage.

PIN diodes are diodes with an undoped intrinsic or low-doped semiconductor region between a heavily doped, p-type semiconductor region (p-well) and a heavily-doped, n-type semiconductor region (n-well). PIN diodes are used in a wide variety of applications. For example, PIN diodes may be employed as attenuators, photodetectors, switches and in high-power radio frequency and microwave applications. One challenge with PIN diodes is attaining a high breakdown voltage, i.e., a minimum reverse voltage that makes the PIN diode conduct in a reverse direction. Various approaches to provide additional high voltage isolation structures in a semiconductor substrate of the PIN diode have been used to increase the breakdown voltage of the PIN diode. The additional isolation structures require additional processing, e.g., mask layers, implants, that are time consuming and expensive. Metal field plates at a first metal layer over the PIN diode have also been used to provide high voltage isolation to increase the breakdown voltage of the PIN diode. However, the metal field plates require extensive area and might reduce the space available for routing.

### SUMMARY

All aspects, examples and features mentioned below can be combined in any technical possible way.

An aspect of the disclosure provides a diode device, comprising: a first well in a semiconductor substrate; a second well in the semiconductor substrate surrounding the first well, wherein the first well and the second well have opposite conductivity types; a low-doped region between the first well and the second well in the semiconductor substrate; and a field plate structure over the low-doped region between the wells, wherein the field plate structure includes at least one of: a single crystal semiconductor over a first dielectric layer, and a polyconductor gate over a second dielectric layer.

An aspect of the disclosure provides a diode device, comprising: a n-well in a semiconductor substrate; a p-well in the semiconductor substrate surrounding the n-well; a low-doped region between the n-well and the p-well in the semiconductor substrate, wherein the low-doped region surrounds the n-well, and the n-well and the p-well each have a higher dopant concentration than the low-doped region; and a field plate structure over the low-doped region between the wells, wherein the field plate structure includes at least one of: a single crystal semiconductor over a first dielectric layer, and a polyconductor gate over a second dielectric layer, wherein the n-well and the low-doped region are biased to a first voltage and the p-well is biased to a second voltage, and the first voltage is higher than the second voltage.

An aspect of the disclosure provides a diode device, comprising: a n-well in a semiconductor substrate; a p-well in the semiconductor substrate surrounding the n-well; an intrinsic region between the n-well and the p-well in the semiconductor substrate, wherein the intrinsic region surrounds the n-well; and a field plate structure over the intrinsic region between the wells, wherein the field plate structure includes at least one of: a semiconductor-on-insulator member including a single crystal semiconductor layer over a buried dielectric layer, and a polyconductor gate over a gate dielectric layer, wherein the n-well and the intrinsic region are biased to a first voltage and the p-well is biased to a second voltage, and the first voltage is higher than the second voltage, wherein the n-well is biased to a first voltage and the p-well is biased to a second voltage, and the first voltage is higher than the second voltage, and the intrinsic region is biased to a third voltage different than the first and second voltages.

Two or more aspects described in this disclosure, including those described in this summary section, may be combined to form implementations not specifically described herein. The details of one or more implementations are set forth in the accompanying drawings and the description below. Other features, objects and advantages will be apparent from the description and drawings, and from the claims.

### BRIEF DESCRIPTION OF THE DRAWINGS

The embodiments of this disclosure will be described in detail, with reference to the following figures, wherein like designations denote like elements, and wherein:
FIG. 1 shows a cross-sectional view of a diode device including a field plate structure, according to embodiments of the disclosure.
FIG. 2 shows a cross-sectional view along view line A-A in FIG. 1.
FIG. 3 shows a cross-sectional view of a diode device including a field plate structure, according to other embodiments of the disclosure.
FIG. 4 shows a cross-sectional view along view line B-B in FIG. 3.
FIG. 5 shows a cross-sectional view of a diode device including a field plate structure, according to additional embodiments of the disclosure.
FIG. 6 shows a cross-sectional view of a diode device including a field plate structure, according to yet additional embodiments of the disclosure.
FIG. 7 shows a cross-sectional view of a diode device including a field plate structure, according to other embodiments of the disclosure.
FIG. 8 shows a cross-sectional view of a diode device including a field plate structure, according to yet other embodiments of the disclosure.
FIG. 9 shows a cross-sectional view of a diode device including a field plate structure, according to more embodiments of the disclosure.
FIG. 10A shows a schematic top-down view of a diode device including a field plate structure, according to embodiments of the disclosure.
FIG. 10B shows a cross-sectional view of a diode device including a field plate structure, according to embodiments of the disclosure.
FIG. 10C shows a cross-sectional view of a diode device including a field plate structure, according to embodiments of the disclosure.
FIG. 10D shows a cross-sectional view of a diode device including a field plate structure, according to embodiments of the disclosure.
FIG. 11 shows a cross-sectional view of a diode device including a field plate structure, according to other embodiments of the disclosure.

It is noted that the drawings of the disclosure are not necessarily to scale. The drawings are intended to depict only typical aspects of the disclosure, and therefore should not be considered as limiting the scope of the disclosure. In the drawings, like numbering represents like elements between the drawings.

### DETAILED DESCRIPTION

In the following description, reference is made to the accompanying drawings that form a part thereof, and in which is shown by way of illustration specific embodiments in which the present teachings may be practiced. These embodiments are described in sufficient detail to enable those skilled in the art to practice the present teachings, and it is to be understood that other embodiments may be used and that changes may be made without departing from the scope of the present teachings. The following description is, therefore, merely illustrative.

It will be understood that when an element such as a layer, region, or substrate is referred to as being "on" or "over" another element, it may be directly on the other element or intervening elements may also be present. In contrast, when an element is referred to as being "directly on" or "directly over" another element, there may be no intervening elements present. It will also be understood that when an element is referred to as being "connected" or "coupled" to another element, it may be directly connected or coupled to the other element or intervening elements may be present. In contrast, when an element is referred to as being "directly connected" or "directly coupled" to another element, there are no intervening elements present.

Reference in the specification to "one embodiment" or "an embodiment" of the present disclosure, as well as other variations thereof, means that a particular feature, structure, characteristic, and so forth described in connection with the embodiment is included in at least one embodiment of the present disclosure. Thus, the phrases "in one embodiment" or "in an embodiment," as well as any other variations appearing in various places throughout the specification are not necessarily all referring to the same embodiment. It is to be appreciated that the use of any of the following "/," "and/or," and "at least one of," for example, in the cases of "A/B," "A and/or B" and "at least one of A and B," is intended to encompass the selection of the first listed option (A) only, or the selection of the second listed option (B) only, or the selection of both options (A and B). As a further example, in the cases of "A, B, and/or C" and "at least one of A, B, and C," such phrasing is intended to encompass the first listed option (A) only, or the selection of the second listed option (B) only, or the selection of the third listed option (C) only, or the selection of the first and the second listed options (A and B), or the selection of the first and third listed options (A and C) only, or the selection of the second and third listed options (B and C) only, or the selection of all three options (A and B and C). This may be extended, as readily apparent by one of ordinary skill in the art, for as many items listed.

Embodiments of the disclosure include a diode device. The diode device includes a first well in a semiconductor substrate, a second well in the semiconductor substrate surrounding the first well, and a low-doped region between the first well and the second well in the semiconductor substrate. The first well and the second well have opposite conductivity types, creating a PIN diode. The diode device also includes a field plate structure over the low-doped region between the wells. The field plate structure includes a single crystal semiconductor over a first dielectric layer and/or a polyconductor gate over a second dielectric layer. The field plate structure provides electric field control resulting in increased breakdown voltage for the PIN diode at reduced costs compared to conventional processes. In certain embodiments, the diode device may have a breakdown voltage of greater than 35 Volts. In another implementation, the potential on the low-doped region could be different from the potential on the n-well.

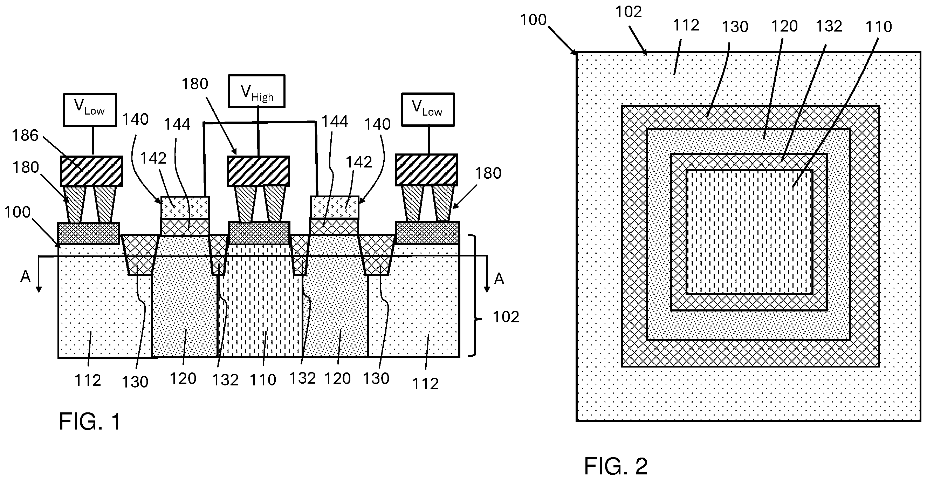

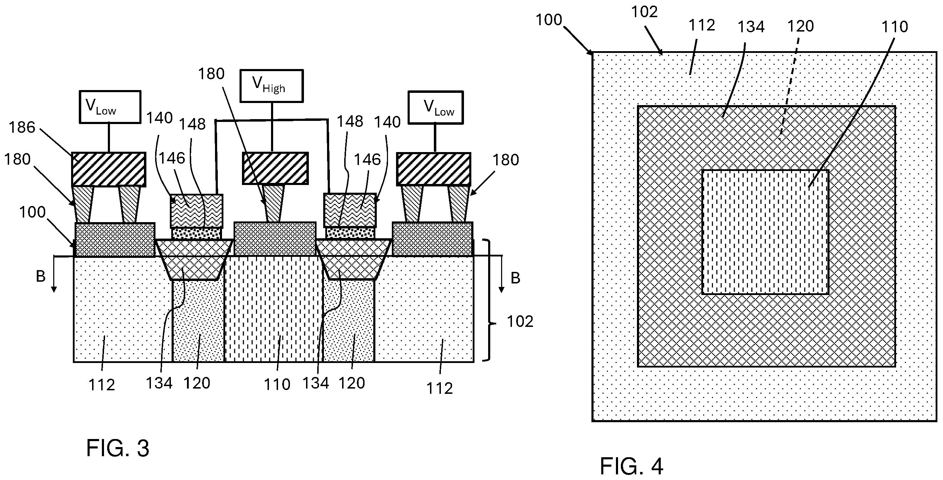

FIG. 1 shows a cross-sectional view of a diode device 100 according to embodiments of the disclosure, and FIG. 2 shows a cross-sectional view along view line A-A in FIG. 1. FIG. 3 shows a cross-sectional view of a diode device 100, according to other embodiments of the disclosure, and FIG. 4 shows a cross-sectional view along view line B-B in FIG. 3. With reference to FIGS. 1-4, diode device 100 (hereafter "device 100" for brevity) includes a semiconductor substrate 102. Semiconductor substrate 102 may include but is not limited to: silicon, germanium, silicon germanium, silicon carbide, and those elements consisting essentially of one or more III-V compound semiconductors having a composition defined by the formula Al_{X1}Ga_{X2}In_{X3}As_{Y1}P_{Y2}N_{Y3}Sb_{Y4}, where X1, X2, X3, Y1, Y2, Y3, and Y4 represent relative proportions, each greater than or equal to zero and X1+X2+X3+Y1+Y2+Y3+Y4=1 (1 being the total relative mole quantity). Other suitable substrates include II-VI compound semiconductors having a composition Zn_{A1}Cd_{A2}Se_{B1}Te_{B2}, where A1, A2, B1, and B2 are relative proportions each greater than or equal to zero and A1+A2+B1+B2=1 (1 being a total mole quantity). Device 100 also includes a first well 110 in semiconductor substrate 102, and a second well 112 in semiconductor substrate 102 surrounding first well 110. First well 110 and second well 112 have opposite conductivity types. For example, first well 110 may be an n-well (hereafter "n-well 110") and second well 112 may be a p-well (hereafter "p-well 112") surrounding n-well 110. That is, the wells 110, 112 are doped with different impurities (i.e., different dopants) to achieve different conductivity types (e.g., P-type conductivity and N-type conductivity). The dopants may vary depending upon the different semiconductor materials used. For example, a silicon-based semiconductor material (e.g., silicon, silicon germanium, etc.) is typically doped with a Group III dopant, such as boron (B) or indium (In), to achieve P-type conductivity for p-well 112, whereas a silicon-based semiconductor material is typically doped with a Group V dopant, such as arsenic (As), phosphorous (P) or antimony (Sb), to achieve N-type conductivity for n-well 110. The dopant concentrations in wells 110, 112 are relatively high, for example, in a range of 1E15 /cm^3 to 1E20 /cm^3. N-well 110 and p-well 112 may be doped using any now known or later developed doping process such as ion implantation and/or in-situ doping during epitaxial growth of semiconductor substrate 102. While embodiments of the disclosure are shown with p-well 112 surrounding n-well 110, it will be recognized that the locations of the wells may be switched.

Device 100 also includes a low-doped region 120 between n-well 110 and p-well 112 in semiconductor substrate 102. As shown in FIG. 2, low-doped region 120 surrounds n-well 110; however, it may surround p-well 112 where the positions of the wells are switched. Where low-doped region 120 includes very low dopant concentrations, it may be also considered an "intrinsic region." Hence, device 100 may also be referenced as a PIN diode, i.e., p-type, intrinsic, n-type diode. As used herein, "low-doped" means semiconductor substrate 102 may have no or a very low dopant concentration of one or both of the n-type or p-type dopants used to dope n-well 110 or p-well 112. Hence, the additional low-doped region 120 could include any of an intrinsic region, a first-type conductivity region at a lower conductivity level than n-well 110, and a second-type conductivity region at a lower conductivity level than p-well 112. The dopant concentrations in low-doped region 120 can be, for example, in a range of 0 to 1E15 /cm^3. In any event, n-well 110 and p-well 112 each have a higher dopant concentration than low-doped region 120. Those skilled in the art will also recognize that different conductivity levels will depend upon the relative concentration levels of the dopant(s) in a given semiconductor region. wherein the additional region is any of an intrinsic region, a first-type conductivity region at a lower conductivity level than the first well, and a second-type conductivity region at a lower conductivity level than the second well.

In certain embodiments, device 100 may also include various trench isolations to electrically isolate at least portions of adjacent wells/regions. For example, as shown in FIGS. 1-2, a first trench isolation 130 separates low-doped region 120 from p-well 112, i.e., at an upper region thereof. In other embodiments, as also shown in FIGS. 1-2, device 100 may further include a second trench isolation 132 separating low-doped region 120 from n-well 110, i.e., at an upper region thereof. As shown in FIG. 2, first trench isolation 130 surrounds low-doped region 120, and second trench isolation 132 surrounds n-well 110.

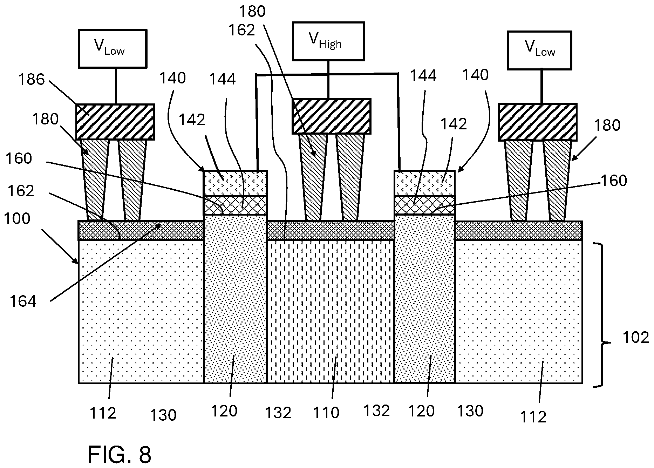

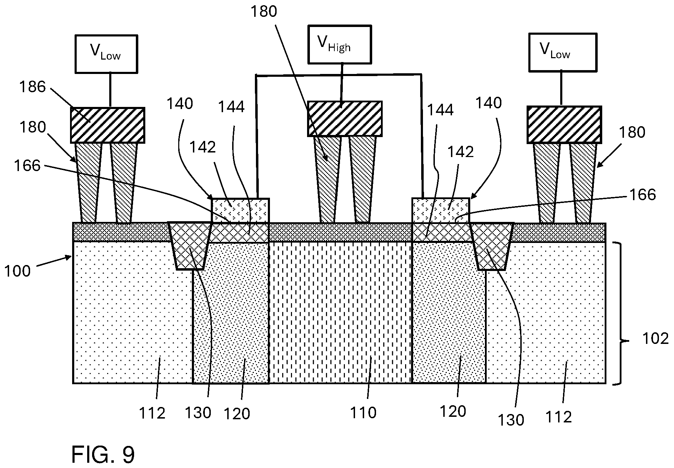

FIGS. 3 and 4 show another embodiment including a single trench isolation 134 over low-doped region 120 and separating n-well 110 and p-well 112, i.e., at upper ends thereof. More particularly, trench isolation 134 is in semiconductor substrate 102 between second dielectric layer 148 and low-doped region 120. Trench isolation 134 is also between p-well 112 and n-well 110, i.e., upper ends thereof. As shown in FIG. 4, trench isolation 134 extends over low-doped region 120 (dashed line) and surrounds n-well 110, and p-well 112 surrounds trench isolation 134. As will be further described herein, FIG. 8 shows an embodiment with no trench isolations, and FIG. 9 shows an embodiment with only first trench isolation 130 between low-doped region 120 and p-well 112.

Trench isolations 130, 132, 134 may be formed using any now known or later developed technique, e.g., etching a trench into semiconductor substrate 102 and filling the trench with an insulating material such as silicon oxide, to isolate one region of the substrate from an adjacent region of the substrate. Each trench isolation 130, 132, 134 may be formed of any currently-known or later developed substance for providing electrical insulation, and as examples may include: silicon nitride, silicon oxide, fluorinated silicon glass (oxide)(FSG), hydrogenated silicon oxycarbide (SiCOH), porous SiCOH, boro-phospho-silicate glass (BPSG), silsesquioxanes, carbon doped oxides (i.e., organosilicates) that include atoms of silicon, carbon, oxygen, and/or hydrogen, thermosetting polyarylene ethers, a spin-on silicon-carbon containing polymer material, or layers thereof.

Device 100 also includes a field plate structure 140 over low-doped region 120 between wells 110, 112. As will be further described herein, field plate structure 140 includes at least one of a single crystal semiconductor over a first dielectric layer, and a polyconductor gate over a second dielectric layer.

In FIG. 1, field plate structure 140 includes a single crystal semiconductor 142 over a first dielectric layer 144. Single crystal or monocrystalline semiconductor 142 and first dielectric layer 144 may be provided as part of a semiconductor-on-insulator (SOI) layer used for other electric devices, e.g., transistors, formed in different locations on semiconductor substrate 102 than device 100. An SOI layer includes a layered semiconductor-insulator-semiconductor substrate 102 in place of a more conventional silicon substrate (bulk substrate). The SOI layer includes single crystal semiconductor 142 over a buried insulator layer, i.e., first dielectric layer 144, over base semiconductor substrate 102. Single crystal semiconductor 142 may include any single crystal semiconductor material listed herein for semiconductor substrate 102, e.g., silicon. First dielectric layer 144 may include any appropriate buried insulator/dielectric such as but not limited to silicon oxide, i.e., forming a buried oxide (BOX) layer. As illustrated, first dielectric layer 144 directly contacts low-doped region 120 between first and second trench isolations 130, 132. The precise thickness of single crystal semiconductor 142 and first dielectric layer 144 may vary widely with the intended application in other regions of semiconductor substrate 102. Field plate structure 140 as described relative to FIG. 1 may be formed and patterned during the same processes used in different areas of semiconductor substrate 102 for other devices, such as transistors. In this manner, field plate structure 140 provides the desired field plate structure functioning to improve breakdown voltage for device 100 but without additional time and costs.

FIG. 3 shows field plate structure 140 including a polyconductor gate 146 over a second dielectric layer 148. Single trench isolation 134 over low-doped region 120 separating n-well 110 and p-well 112 would also be part of field plate structure 140 in this arrangemetn. Polyconductor gate 146 and second dielectric layer 148 may be provided as part of gate forming for transistors in different locations on semiconductor substrate 102 than device 100. Polyconductor gate 146 may include any materials typically used for a polysilicon gate or a metal gate for transistors. For metal gates, polyconductor gate 146 may include a number of layers (not all shown for clarity) including, for example, a work function tuning layer and a gate conductor. The high-K layer may include any now known or later developed high-K material typically used for metal gates such as but not limited to: metal oxides such as tantalum oxide (Ta₂O₅), barium titanium oxide (BaTiO₃), hafnium oxide (HfO₂), zirconium oxide (ZrO₂), aluminum oxide (Al₂O₃) or metal silicates such as hafnium silicate oxide (Hf_{A1}Si_{A2}O_{A3}) or hafnium silicate oxynitride (Hf_{A1}Si_{A2}O_{A3}N_{A4}), where A1, A2, A3, and A4 represent relative proportions, each greater than or equal to zero and A1+A2+A3+A4 (1 being the total relative mole quantity). The work function tuning layer may include various metals depending on whether the SOI layer is used an NFET or PFET device elsewhere on semiconductor substrate 102. The work function tuning layer may include, for example: aluminum (Al), zinc (Zn), indium (In), copper (Cu), indium copper (InCu), tin (Sn), tantalum (Ta), tantalum nitride (TaN), tantalum carbide (TaC), titanium (Ti), titanium nitride (TiN), titanium carbide (TiC), TiAlC, TiAl, tungsten (W), tungsten nitride (WN), tungsten carbide (WC), polycrystalline silicon (poly-Si), and/or combinations thereof. The gate conductor may include any now known or later developed gate conductor such as copper (Cu). A gate cap (not shown) of, for example, a nitride may also be formed over the gate conductor.

Second dielectric layer 148 may include any now known or later developed gate dielectric materials such as but not limited to hafnium silicate (HfSiO), hafnium oxide (HfO₂), zirconium silicate (ZrSiOₓ), zirconium oxide(ZrO₂), silicon oxide (SiO₂), silicon nitride (Si₃N₄), silicon oxynitride (SiON), high-k material or any combination of these materials. Second dielectric layer 148 is typically different than high-K layer of polyconductor gate 146. Although not shown, field plate structure 140 in FIG. 3 may include a spacer thereabout, which may include any now known or later developed spacer material such as silicon nitride. The precise thickness of polyconductor gate 146 and second dielectric layer 148 may vary widely with the intended application in other regions of semiconductor substrate 102. Field plate structure 140 as described relative to FIG. 3 may be formed and patterned during the same processes used in different areas of semiconductor substrate 102 for gates of transistors. In this manner, field plate structure 140 provides the desired field plate structure functioning to improve breakdown voltage for device 100 but without additional time and costs.

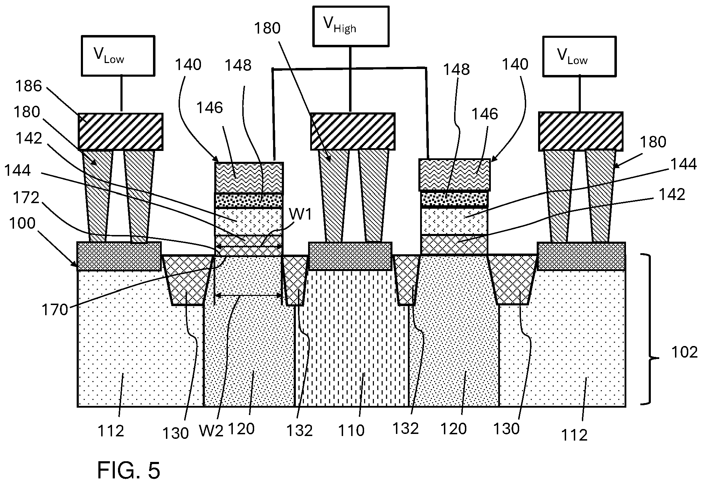

FIG. 5 shows a cross-sectional view of device 100, according to additional embodiments of the disclosure. In FIG. 5, field plate structure 140 includes polyconductor gate 146 over second (gate) dielectric layer 148 over single crystal semiconductor 142 over first (buried) dielectric layer 144 over low-doped region 120. Field plate structure 140 as described relative to FIG. 5 may be formed and patterned during the same processes used in different areas of semiconductor substrate 102 for SOI layers for gates of various transistors. In this manner, field plate structure 140 provides the desired field plate structure functioning to improve breakdown voltage for device 100 but without additional time and costs.

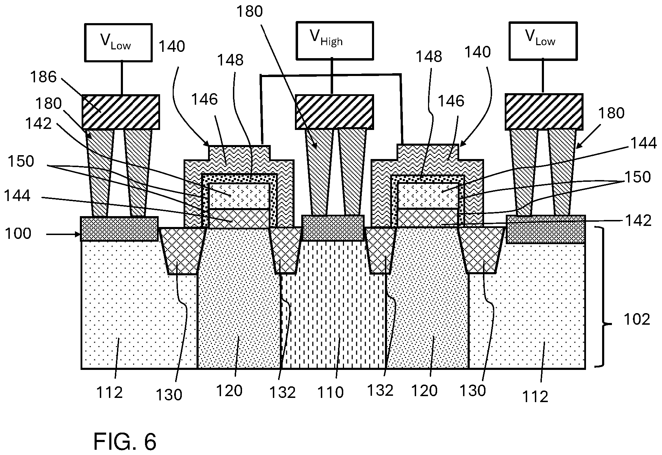

FIG. 6 shows a cross-sectional view of device 100, according to additional embodiments of the disclosure. In FIG. 6, field plate structure 140 includes the same layers as described relative to FIG. 5 except polyconductor gate 146 and second (gate) dielectric layer 148 also extend along sidewalls 150 of single crystal semiconductor 142 and first (buried) dielectric layer 144. Hence, polyconductor gate 146 and second (gate) dielectric layer 148 wrap around single crystal semiconductor 142 and first (buried) dielectric layer 144.

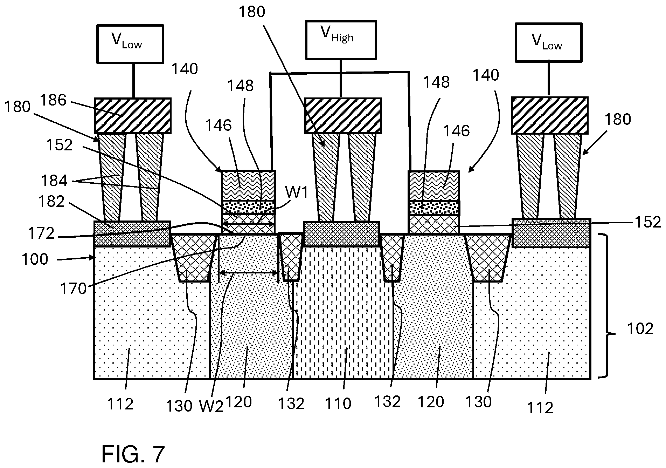

FIG. 7 shows a cross-sectional view of device 100, according to other embodiments of the disclosure. In FIG. 7, field plate structure 140 includes the same layers as described relative to FIG. 5 except single crystal semiconductor 142 is omitted. Here, polyconductor gate 146 is over second (gate) dielectric layer 148 over low-doped region 120, but a third dielectric layer 152 is between second (gate) dielectric layer 148 and low-doped region 120. Third dielectric layer 152 includes different material than second (gate) dielectric layer 148, i.e., silicon oxide and hafnium oxide, respectively. In certain embodiments, third dielectric layer 152 may be the same as first (buried) dielectric layer 144. Hence, field plate structure 140 may include polyconductor gate 146 over second (gate) dielectric layer 148 over first (buried) dielectric layer 144 over low-doped region 120.

FIG. 8 shows a cross-sectional view of device 100, according to yet other embodiments of the disclosure. FIG. 8 includes field plate structure 140 as described relative to FIG. 1, i.e., with single crystal semiconductor 142 over first (buried) insulator layer 144. In FIG. 8, however, low-doped region 120 has an upper surface 160 extending beyond an upper surface 162 of n-well 110 and p-well 112. Here, first dielectric layer 144 contacts the upper surface of low-doped region 120. In other cases, upper surface 162 can be at a same height as upper surface 160 or upper surface 162 could be slightly above upper surface 160 when further epitaxial growth is performed in bulk active region 164 after removal of single crystal semiconductor 142 and first (buried) insulator layer 144 thereover. The upper interface of bulk active region 164 (see indicated arrow on FIG. 8) has to be substantially below the lower surface of single crystal semiconductor 142 in order to allow first (buried) insulator layer 144 to decouple bulk active region 164 and single crystal semiconductor 142 electrically, i.e. the dielectric breakdown voltage along the path 142-144-164 must be higher than the breakdown of the PIN diode with a field plate. In any event, as noted previously, the FIG. 8 embodiment is devoid of trench isolations. Field plate structure 140 and, in particular, the low-doped region 120 may be formed and patterned during the same processes used in different areas of semiconductor substrate 102 for SOI layers. In this manner, field plate structure 140 provides the desired field plate structure functioning to improve breakdown voltage for device 100 but without additional time and costs.

FIG. 9 shows a cross-sectional view of device 100, according to more embodiments of the disclosure. FIG. 9 includes field plate structure 140 as described relative to FIG. 1, i.e., with single crystal semiconductor 142 over first (buried) insulator layer 144. In FIG. 9, however, second, inner trench isolation 132 (FIG. 1) is omitted and only first, outer trench isolation 130 is used. In addition, first (buried) dielectric layer 144 and single crystal semiconductor 142 could be positioned lower than in FIG. 1. Single crystal semiconductor 142 over first dielectric layer 144 can be removed in required areas in order to expose bulk substate 102. Afterwards, trench isolation 130, active regions 182 and contacts 180 can be formed in a known fashion.

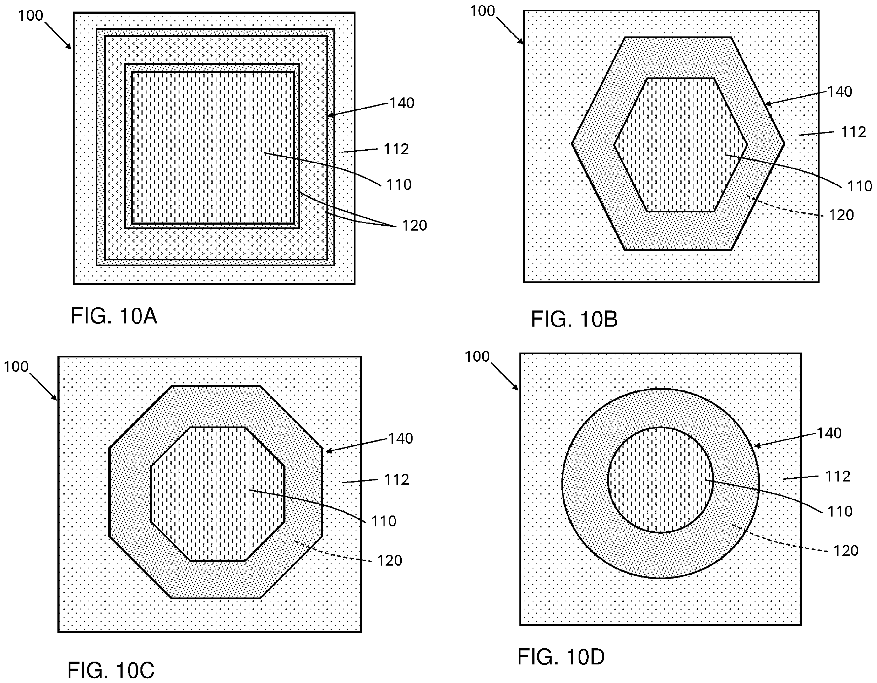

In any of the embodiments of FIGS. 1, 3, 5-9, and as shown in FIGS. 5 and 7 only for clarity, field plate structure 140 has a lower surface 170 having a width W1 less than or equal to a width W2 of an upper surface 172 of low-doped region 120. FIG. 5 shows an example where they are substantially equal, and FIG. 7 shows an example where field plate structure 140 has lower surface 170 having width W1 less than width W2 of upper surface 172 of low-doped region 120. FIG. 10A also shows an example where field plate structure 140 has a width less than low-doped region 120. In another option, as shown in FIG. 6, field plate structure 140 has a lower surface (not labeled for clarity) having a width greater than a width of an upper surface of low-doped region 120. It will be clear to those skilled in the art that widths W1 and W2 could differ in order to achieve optimal electrical field spreading.

Diode device 100 may include any now known or later developed contacts 180 to the parts of the diode. (Note, the contacts from a high voltage source (V_{high}) to field plate structure 140 and a contact 180 to low-doped region 120 are shown schematically with lines in FIGS. 1, 3 and 5-9 for clarity.) Contacts 180 may include any now known or later developed contact structure appropriate for the materials being contacted. For example, as shown only on the left side of FIG. 7 for clarity, contacts 180 to n-well 110, p-well 112 and low-doped region 120 in semiconductor substrate 102 may include silicide layers 182 contacting the respective part of semiconductor substrate 102 and one or more metal contacts 184, e.g., conductors such as copper in a refractory metal liner in a dielectric. At an upper end thereof, contacts 180 may couple to, for example, a first metal layer 186. Where contacts connect to polyconductor gate 146 in the form of metal, the silicide may be omitted. As understood in the field, contacts 180 are formed in, or surrounded by, one or more dielectric layers (not labeled). Contacts 180 may be formed using any now known or later developed techniques.

Referring to FIGS. 2, 4 and 10A-D, low-doped region 120 may have a variety of different a cross-sectional ring shapes surrounding n-well 110. Similarly, field plate structure 140 over low-doped region 120 may have a variety of different cross-sectional ring shapes that mirror that of low-doped region 120. As noted, one of wells 110, 112, e.g., n-well 110 as illustrated, is inside the cross-sectional ring shape of low-doped region 120. FIG. 10A shows a schematic top-down view of device 100 including field plate structure 140 (FIG. 1 version) over low-doped region 120, and FIGS. 10B-D show cross-sectional views along view lines similar to A-A in FIG. 1 and B-B in FIG. 2. In FIGS. 2, 4 and 10A, low-doped region 120 has a rectangular (perhaps square) cross-sectional ring shape. In FIG. 10B, low-doped region 120 has a hexagonal cross-sectional ring shape. In FIG. 10C, low-doped region 120 has an octagonal cross-sectional ring shape. In FIG. 10D, low-doped region 120 has a circular (or perhaps oval) cross-sectional ring shape. Other cross-sectional ring shapes are also possible.

In operation, as shown in FIGS. 1, 3 and 5-9, n-well 110 and low-doped region 120 are biased to a first voltage (V_{high}), and p-well 112 is biased to a second voltage (V_{low}). As indicated by the reference labels, first voltage (V_{high}) is higher than second voltage (V_{low}). Due to the presence of field plate structure 140 according to any of the embodiments described herein, device 100 may have a breakdown voltage of greater than 35 Volts. Conventional PIN diodes without metal field plates have breakdown voltages that are at least 10 Volts lower.

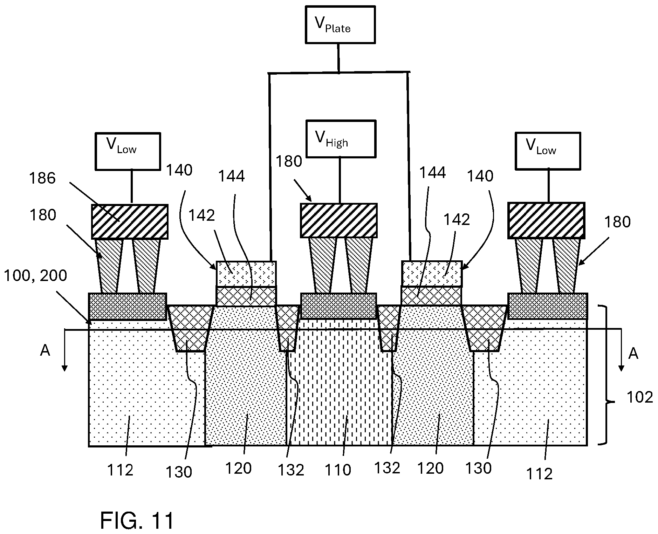

FIG. 11 shows a cross-sectional view of a diode device including a field plate structure, according to other embodiments of the disclosure. FIG. 11 shows an embodiment, based on the FIG. 1 structure but applicable to all embodiments described herein. In this alternative version, low-doped (intrinsic) region 120 is connected to a different potential than V_{high}, e.g., a Vₚₗₐₜₑ, which provides a variable breakdown voltage PIN diode 200. More specifically, n-well 110 is biased to a first voltage (V_{high}) and p-well 112 is biased to a second voltage (V_{low}), and the first voltage is higher than the second voltage. Further, low-doped (intrinsic) region 120 (via field plate 140) is biased to a third voltage (Vₚₗₐₜₑ) different than the first and second voltages (or at least different than the first voltage on n-well 110). Again, the use of independent voltage Vₚₗₐₜₑ can be use in any embodiment described herein as an alternative, i.e., any of FIGS. 3, 5-9.

Embodiments of the disclosure provide various technical and commercial advantages, examples of which are discussed herein. The diode device including the field plate structures described herein provides high voltage isolation resulting in increased breakdown voltage for the PIN diode. Since the field plate structures are formed as part of already existing processes the diode device can be formed at reduced costs compared to conventional devices. As noted, the diode device may have a breakdown voltage of greater than 35 Volts. In other implementations, the potential on the low-doped region could be different from the potential on the n-well, providing a variable breakdown voltage PIN diode.

The structure and method as described above are used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher-level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The terminology used herein is for the purpose of describing particular embodiments only and is not intended to be limiting of the disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. "Optional" or "optionally" means that the subsequently described event or circumstance may or may not occur, and that the description includes instances where the event occurs and instances where it does not.

Approximating language, as used herein throughout the specification and claims, may be applied to modify any quantitative representation that could permissibly vary without resulting in a change in the basic function to which it is related. Accordingly, a value modified by a term or terms, such as "about", "approximately" and "substantially", are not to be limited to the precise value specified. In at least some instances, the approximating language may correspond to the precision of an instrument for measuring the value. Here and throughout the specification and claims, range limitations may be combined and/or interchanged, such ranges are identified and include all the sub-ranges contained therein unless context or language indicates otherwise. "Approximately" as applied to a particular value of a range applies to both values, and unless otherwise dependent on the precision of the instrument measuring the value, may indicate +/-10% of the stated value(s).

The corresponding structures, materials, acts, and equivalents of all means or step plus function elements in the claims below are intended to include any structure, material, or act for performing the function in combination with other claimed elements as specifically claimed. The description of the present disclosure has been presented for purposes of illustration and description but is not intended to be exhaustive or limited to the disclosure in the form disclosed. Many modifications and variations will be apparent to those of ordinary skill in the art without departing from the scope and spirit of the disclosure. The embodiment was chosen and described in order to best explain the principles of the disclosure and the practical application, and to enable others of ordinary skill in the art to understand the disclosure for various embodiments with various modifications as are suited to the particular use contemplated.

In summary, a diode device is disclosed. The diode device includes a first well in a semiconductor substrate, a second well in the semiconductor substrate surrounding the first well, and a low-doped region between the first well and the second well in the semiconductor substrate. The first well and the second well have opposite conductivity types, creating a PIN diode. The diode device also includes a field plate structure over the low-doped region between the wells. The field plate structure includes a single crystal semiconductor over a first dielectric layer and/or a polyconductor gate over a second dielectric layer. The field plate structure provides high voltage isolation resulting in increased breakdown voltage for the PIN diode at reduced costs compared to conventional processes. In certain embodiments, the diode device may have a breakdown voltage of greater than 35 Volts.

The following embodiments are explicitly disclosed.

### Embodiment 1:

A diode device, comprising:
a first well in a semiconductor substrate;
a second well in the semiconductor substrate surrounding the first well, wherein the first well and the second well have opposite conductivity types;
a low-doped region between the first well and the second well in the semiconductor substrate; and
a field plate structure over the low-doped region between the wells, wherein the field plate structure includes at least one of:
   a single crystal semiconductor over a first dielectric layer, and
   a polyconductor gate over a second dielectric layer.

In illustrative embodiments herein, the low-doped region may have a dopant concentration of zero (such that the low-doped region is undoped and represents an intrinsic region) or a dopant concentration lower than a dopant concentration of at least one of the first well and the second well. Additionally or alternatively, the low-doped region may be doped with dopants used to dope at least one of the first well and the second well.

### Embodiment 2:

The diode device of embodiment 1, further comprising a first trench isolation separating the low-doped region from the second well.

### Embodiment 3:

The diode device of embodiment 2, further comprising a second trench isolation separating the low-doped region from the first well, and wherein the first dielectric layer directly contacts the low-doped region between the first and second trench isolations.

### Embodiment 4:

The diode device of one of embodiments 1 to 3, further comprising a trench isolation in the semiconductor substrate between the second dielectric layer and the low-doped region.

### Embodiment 5:

The diode device of one of embodiments 1 to 4, wherein the field plate structure includes the polyconductor gate over the second dielectric layer over the single crystal semiconductor over the first dielectric layer over the low-doped region.

### Embodiment 6:

The diode device of embodiment 5, wherein the polyconductor gate and the second dielectric layer extend along sidewalls of the single crystal semiconductor and the first dielectric layer.

### Embodiment 7:

The diode device of one of embodiments 1 to 6, wherein the polyconductor gate over the second dielectric layer over the low-doped region includes a third dielectric layer between the second dielectric layer and the low-doped region, wherein the third dielectric layer includes different material than the second dielectric layer.

### Embodiment 8:

The diode device of one of embodiments 1 to 7, wherein the low-doped region has an upper surface extending beyond an upper surface of the first well and the second well, and the first dielectric layer contacts the upper surface of the low-doped region.

### Embodiment 9:

The diode device of one of embodiments 1 to 8, wherein the field plate structure has a lower surface having a width less than or equal to a width of an upper surface of the low-doped region.

### Embodiment 10:

The diode device of one of embodiments 1 to 9, wherein the first well and the low-doped region are biased to a first voltage, and the second well is biased to a second voltage and the first voltage is higher than the second voltage.

### Embodiment 11:

A diode device, comprising:
a n-well in a semiconductor substrate;
a p-well in the semiconductor substrate surrounding the n-well;
a low-doped region between the n-well and the p-well in the semiconductor substrate, wherein the low-doped region surrounds the n-well, and the n-well and the p-well each have a higher dopant concentration than the low-doped region; and
a field plate structure over the low-doped region between the wells, wherein the field plate structure includes at least one of:
   a single crystal semiconductor over a first dielectric layer, and
   a polyconductor gate over a second dielectric layer,
wherein the n-well and the low-doped region are biased to a first voltage and the p-well is biased to a second voltage, and the first voltage is higher than the second voltage.

### Embodiment 12:

The diode device of one of embodiments 1 to 11, wherein:
the first well comprises a n-well in the semiconductor substrate;
the second well comprises a p-well in the semiconductor substrate surrounding the n-well;
the low-doped region is arranged between the n-well and the p-well in the semiconductor substrate, the low-doped region surrounding the n-well, and the n-well and the p-well each having a higher dopant concentration than the low-doped region; and
the n-well and the low-doped region are biased to a first voltage and the p-well is biased to a second voltage, and the first voltage is higher than the second voltage.

### Embodiment 13

The diode device of embodiment 11 or 12, further comprising a first trench isolation separating the low-doped region from the p-well.

### Embodiment 14:

The diode device of embodiment 13, further comprising a second trench isolation separating the low-doped region from the n-well, and wherein the first dielectric layer directly contacts the low-doped region between the first and second trench isolations.

### Embodiment 15:

The diode device of one of embodiments 11 to 14, further comprising a trench isolation in the semiconductor substrate between the second dielectric layer and the low-doped region.

### Embodiment 16:

The diode device of one of embodiments 11 to 15, wherein the field plate structure includes the polyconductor gate over the second dielectric layer over the single crystal semiconductor over the first dielectric layer over the low-doped region.

### Embodiment 17:

The diode device of one of embodiments 11 to 16, wherein the polyconductor gate and the second dielectric layer extend along sidewalls of the single crystal semiconductor and the first dielectric layer.

### Embodiment 18:

The diode device of one of embodiments 11 to 17, wherein the polyconductor gate over the second dielectric layer over the low-doped region includes a third dielectric layer between the second dielectric layer and the low-doped region, wherein the third dielectric layer includes different material than the second dielectric layer.

### Embodiment 19:

The diode device of one of embodiments 11 to 18, wherein the low-doped region has an upper surface extending beyond an upper surface of the n-well and the p-well, and the first dielectric layer contacts the upper surface of the low-doped region.

### Embodiment 20:

The diode device of one of embodiments 11 to 19, wherein the single crystal semiconductor and the first dielectric layer are part of a semiconductor-on-insulator layer, and the first dielectric layer directly contacts the low-doped region.

### Embodiment 21:

The diode device of one of embodiments 11 to 20, further comprising:
an intrinsic region between the n-well and the p-well in the semiconductor substrate, wherein the intrinsic region surrounds the n-well; and
a second field plate structure over the intrinsic region between the wells, wherein the second field plate structure includes at least one of:
   a semiconductor-on-insulator member including a single crystal semiconductor layer over a buried dielectric layer, and
   a polyconductor gate over a gate dielectric layer,
wherein the intrinsic region is biased to a third voltage different than the first and second voltages.

### Embodiment 22:

The diode device of one of embodiments 11 to 20, further comprising:
an intrinsic region between the n-well and the p-well in the semiconductor substrate, wherein the intrinsic region surrounds the n-well;
wherein the field plate structure is arranged over the intrinsic region between the wells, and
wherein the intrinsic region is biased to a third voltage different than the first and second voltages,
wherein the field plate structure preferably includes at least one of:
   a semiconductor-on-insulator member including a single crystal semiconductor layer over a buried dielectric layer, and
   a polyconductor gate over a gate dielectric layer.

### Embodiment 23:

A diode device, comprising:
a n-well in a semiconductor substrate;
a p-well in the semiconductor substrate surrounding the n-well;
an intrinsic region between the n-well and the p-well in the semiconductor substrate, wherein the intrinsic region surrounds the n-well; and
a field plate structure over the intrinsic region between the wells, wherein the field plate structure includes at least one of:
   a semiconductor-on-insulator member including a single crystal semiconductor layer over a buried dielectric layer, and
   a polyconductor gate over a gate dielectric layer,
wherein the n-well is biased to a first voltage and the p-well is biased to a second voltage, and the first voltage is higher than the second voltage, and the intrinsic region is biased to a third voltage different than the first and second voltages.

## Claims

1. A diode device, comprising:
a first well in a semiconductor substrate;
a second well in the semiconductor substrate surrounding the first well, wherein the first well and the second well have opposite conductivity types;
a low-doped region between the first well and the second well in the semiconductor substrate; and
a field plate structure over the low-doped region between the wells, wherein the field plate structure includes at least one of:
a single crystal semiconductor over a first dielectric layer, and
a polyconductor gate over a second dielectric layer.

2. The diode device of claim 1, further comprising a first trench isolation separating the low-doped region from the second well.

3. The diode device of claim 2, further comprising a second trench isolation separating the low-doped region from the first well, and wherein the first dielectric layer directly contacts the low-doped region between the first and second trench isolations.

4. The diode device of one of claims 1 to 3, further comprising a trench isolation in the semiconductor substrate between the second dielectric layer and the low-doped region.

5. The diode device of one of claims 1 to 4, wherein the field plate structure includes the polyconductor gate over the second dielectric layer over the single crystal semiconductor over the first dielectric layer over the low-doped region.

6. The diode device of claim 5, wherein the polyconductor gate and the second dielectric layer extend along sidewalls of the single crystal semiconductor and the first dielectric layer.

7. The diode device of one of claims 1 to 6, wherein the polyconductor gate over the second dielectric layer over the low-doped region includes a third dielectric layer between the second dielectric layer and the low-doped region, wherein the third dielectric layer includes different material than the second dielectric layer.

8. The diode device of one of claims 1 to 7, wherein the low-doped region has an upper surface extending beyond an upper surface of the first well and the second well, and the first dielectric layer contacts the upper surface of the low-doped region.

9. The diode device of one of claims 1 to 8, wherein the field plate structure has a lower surface having a width less than or equal to a width of an upper surface of the low-doped region.

10. The diode device of one of claims 1 to 9, wherein the first well and the low-doped region are biased to a first voltage, and the second well is biased to a second voltage and the first voltage is higher than the second voltage.

11. The diode device of one of claims 1 to 10, wherein the low-doped region has a dopant concentration of zero or a dopant concentration lower than a dopant concentration of at least one of the first well and the second well, and/or wherein the low-doped region is doped with dopants used to dope at least one of the first well and the second well.

12. The diode device of one of claims 1 to 11, wherein:
the first well comprises a n-well in the semiconductor substrate;
the second well comprises a p-well in the semiconductor substrate surrounding the n-well;
the low-doped region is arranged between the n-well and the p-well in the semiconductor substrate, the low-doped region surrounding the n-well, and the n-well and the p-well each having a higher dopant concentration than the low-doped region; and
the n-well and the low-doped region are biased to a first voltage and the p-well is biased to a second voltage, and the first voltage is higher than the second voltage.

13. The diode device of claim 12, wherein the single crystal semiconductor and the first dielectric layer are part of a semiconductor-on-insulator layer, and the first dielectric layer directly contacts the low-doped region.

14. The diode device of claim 12 or 13, further comprising:
an intrinsic region between the n-well and the p-well in the semiconductor substrate, wherein the intrinsic region surrounds the n-well,
wherein the field plate structure is arranged over the intrinsic region between the wells, and
wherein the intrinsic region is biased to a third voltage different than the first and second voltages,
wherein the field plate structure preferably includes at least one of:
a semiconductor-on-insulator member including a single crystal semiconductor layer over a buried dielectric layer, and
a polyconductor gate over a gate dielectric layer.

15. A diode device, comprising:
a n-well in a semiconductor substrate;
a p-well in the semiconductor substrate surrounding the n-well;
an intrinsic region between the n-well and the p-well in the semiconductor substrate, wherein the intrinsic region surrounds the n-well; and
a field plate structure over the intrinsic region between the wells, wherein the field plate structure includes at least one of:
a semiconductor-on-insulator member including a single crystal semiconductor layer over a buried dielectric layer, and
a polyconductor gate over a gate dielectric layer,
wherein the n-well is biased to a first voltage and the p-well is biased to a second voltage, and the first voltage is higher than the second voltage, and the intrinsic region is biased to a third voltage different than the first and second voltages.
